## Europäisches Patentamt
## European Patent Office
## Office européen des brevets

(19)

(11) Numéro de publication: **0 182 700 B1**

(12) **FASCICULE DE BREVET EUROPEEN**

(45) Date de publication du fascicule du brevet:
27.09.89

(51) Int. Cl.⁴: **H 01 R 23/72, H 05 K 7/10**

(21) Numéro de dépôt: **85402128.4**

(22) Date de dépôt: **05.11.85**

(54) Elément de connexion miniature à faible pas, et procédé de fabrication d'un tel élément de connexion.

(30) Priorité: **06.11.84 FR 8416873**

(43) Date de publication de la demande:
**28.05.86 Bulletin 86/22**

(45) Mention de la délivrance du brevet:
**27.09.89 Bulletin 89/39**

(84) Etats contractants désignés:
**DE GB IT**

(56) Documents cités:
**EP-A- 0 001 477**
**DE-A- 2 651 186**
**FR-A- 2 192 437**
**US-A- 3 795 884**
**US-A- 4 395 084**

**PROCEEDINGS OF THE S.I.D., vol. 21, no. 2, 1980, pages 157-164, Los Angles, US; L.S. BUCHOFF: "Metal-elastomeric display connectors"**

(73) Titulaire: **SOCAPEX, 10 bis, quai Léon Blum, F-92153 Suresnes (FR)**

(72) Inventeur: **Legrand, Jacques, THOMSON-CSF SCPI 173, bld Haussmann, F-75379 Paris Cedex 08 (FR)**
Inventeur: **Rouffy, Jean-Claude, THOMSON-CSF SCPI 173, bld Haussmann, F-75379 Paris Cedex 08 (FR)**

(74) Mandataire: **Hasenrader, Hubert et al, Cabinet BEAU DE LOMENIE 55, rue d'Amsterdam, F-75008 Paris (FR)**

## Description

L'invention concerne un élément de connexion miniature à faible pas destiné à réaliser des connexions électriques dans des systèmes électroniques.

La miniaturisation et la complexité de plus en plus poussées des composants électroniques entrainent la multiplication des liaisons conductrices sur des surfaces restreintes.

Les besoins de connexion des composants sur les cartes de circuit imprimé, ou des cartes entre elles, ont fait apparaître une nouvelle technologie de connecteurs basée sur l'utilisation des propriétés élastiques des élastomères.

Dans le document US-A 3 795 884 est décrit un élément de connexion miniature à faible pas, comprenant un corps en élastomère isolant portant des éléments conducteurs disposés pour partie autour dudit corps et noyés pour partie dans ledit corps au voisinage de leurs extrémités.

Les éléments conducteurs ont sensiblement la forme d'anneaux et en cas de rupture d'adhérence entre les éléments et le corps, ce qui peut se produire lorsque les éléments sont revêtus d'une couche d'or et/ou que l'élément de connexion est soumis à des efforts ou vibrations répétés, les parties des éléments noyées dans le corps peuvent s'en échapper et venir en contact indésirable avec un élément voisin, ou plusieurs.

Un dispositif de l'art antérieur, décrit dans le document EP-A 0 001 477, est un connecteur dans lequel on place des parties métalliques autour d'un corps élastomère sous la forme de pistes repliées. Ce connecteur comprend un corps allongé en matériau élastomère isolant de section transversale uniforme et qui présente deux faces opposées plates et parallèles reliées entre elles d'un côté par une surface convexe. Plusieurs chemins conducteurs sont disposés sur ce corps, chacun de ces chemins comprenant une partie de contact sur chacune de ces deux faces opposées du corps et une partie s'étendant, entre ces parties de contact, le long de la surface convexe. Ces chemins conducteurs sont formés d'une lame en matériau élastomère isolant obtenue par des techniques de circuit imprimé et pliée pour former le produit désiré. Cette technique améliore la fiabilité après compression de l'élément de connexion, mais suppose des mises en œuvre délicates du fait, d'une part, des dimensions nécessairement réduites et donc du positionnement précis des parties conductrices et, d'autre part, de la solidité de l'accrochage des parties métalliques sur l'élastomère, celles-ci n'étant pas enserrées par la matière isolante.

La présente invention se réfère à un élément de connexion qui permet une mise en œuvre moins complexe tout en assurant une bonne liaison métal-élastomère et un haut niveau de fiabilité après compressions répétées.

L'invention a pour objet un élément de connexion du type précité, caractérisé en ce que les éléments conducteurs sont des lamelles et que les parties des lamelles noyées dans le corps présentent au moins un pli et affleurent à la surface du corps à leurs extrémités.

L'invention a, en outre, pour objet un procédé de fabrication d'un tel élément de connexion.

L'invention sera mieux comprise à la lecture de la description ci-dessous donnée à titre d'exemple non limitatif, en liaison avec les figures qui représentent:
- les figures 1 et 2, deux vues illustrant la réalisation d'un connecteur selon l'art connu;
- la figure 3, le connecteur selon l'invention;
- les figures 4 à 10, des vues illustrant la réalisation du connecteur selon l'invention.

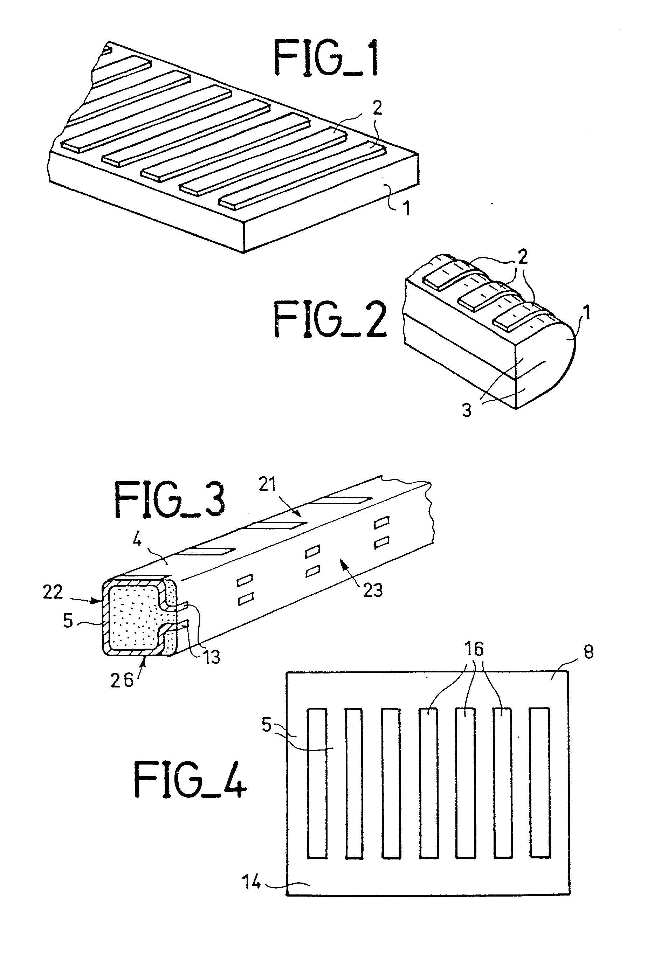

Les figures 1 et 2 illustrent deux étapes de réalisation d'un connecteur selon l'art connu.

La figure 1 représente une lame 1 en matériau isolant qui comporte plusieurs chemins conducteurs, parallèles entre eux, disposés sur l'une de ses faces. Dans ce dispositif de l'art connu, selon le document EP-A 0 001 477, cette lame est pliée, comme représenté à la figure 2, selon une médiane longitudinale, de manière à former un «U» comprenant les chemins conducteurs sur ses faces externes 3. Ce «U» est alors refermé sur lui-même, par application d'une pression entre les faces externes 3. La liaison entre les deux branches du «U» peut-être, par exemple, réalisée par échauffement, en utilisant un matériau élastomère ayant des propriétés thermo-plastiques.

Par contre, l'invention consiste en un élément de connexion miniature à faible pas constitué de l'association d'éléments conducteurs et d'un corps en élastomère isolant, les éléments conducteurs étant des lamelles positionnées de telle façon qu'elles contournent le corps isolant sur la plus grande partie de sa circonférence et pénètrent à l'intérieur sur le reste en formant au moins un pli afin d'assurer une liaison mécanique solide entre ces deux parties du composite, à savoir les lamelles conductrices et le corps isolant.

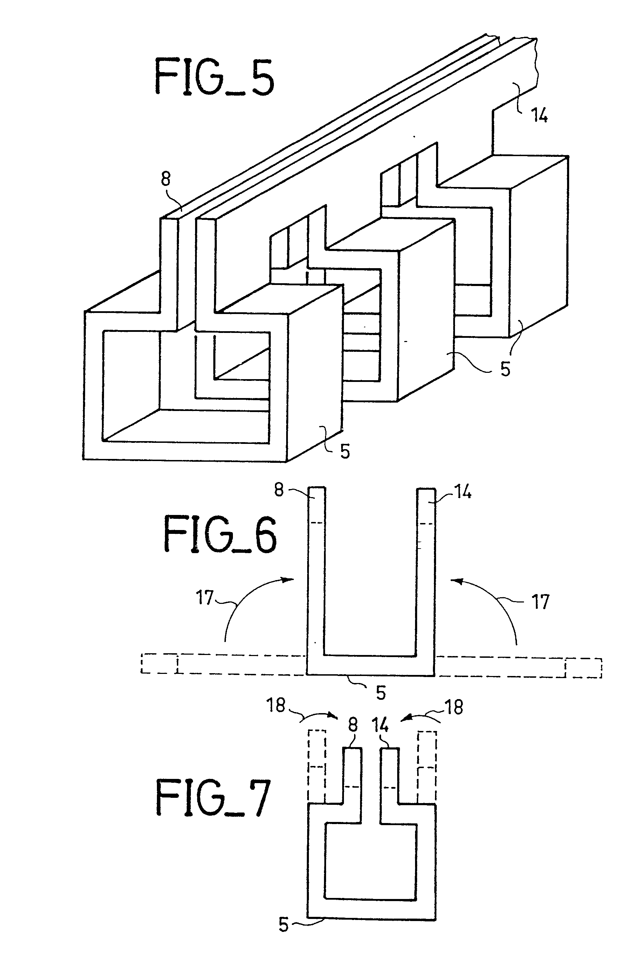

Un mode particulier de réalisation de l'invention est décrit sur la figure 3. Les lamelles conductrices 5 sont associées à l'élastomère isolant 4 qui assure à la fois l'isolement électrique des lamelles conductrices 5 et la fonction de ressort mécanique. A titre d'exemple, ces lamelles conductrices peuvent être en cuivre ou en alliage de cuivre et ce corps isolant en élastomère silicone.

Les lamelles conductrices 5 sont à l'extérieur du corps élastomère sur trois de ses faces 21, 22 et 26. Elles sont internes au corps isolant sur la quatrième face 23 où elles n'émergent que par leurs extrémités 13. Ces lamelles métalliques, pour assurer un bon contact électrique, sont de préférence recouvertes d'une couche d'or, d'une superposition de deux couches nickel et or, d'une couche d'alliage étain-plomb, d'une couche de palladium ou de tout autre revêtement connu de l'homme de l'art, destiné à améliorer la fiabilité du contact électrique. La liaison chimique qui doit assurer leur adhésion au corps élastomère est difficile à réaliser dans le cas d'une couche d'or. Aussi, la partie entrant dans l'élastomère permet de maintenir, en le renforçant, le positionnement des conducteurs métalliques.

A titre d'exemple, le corps élastomère peut être un parallélépipède de section carrée ayant 3 mm de côté. Les bandes métalliques peuvent avoir une largeur de 0,2 mm au pas de 0,4 mm et une épaisseur de 0,1 mm. La mise en œuvre préférée consistera à partir d'une bande large dans laquelle on découpe soit mécaniquement, soit par attaque photo-chimique, les lamelles conductrices à leurs dimensions définitives.

La figure 4 montre de quelle façon sont découpées les parties conductrices parallèles 5. Ces parties conductrices 5 sont maintenues parallèlement par deux bordures pleines 8 et 14 issues de la bande originale et séparées par des interstices 16. Ceci permet, d'une part, de les manipuler sans modifier leurs positions fixées une fois pour toute dès le départ et, d'autre part, d'envisager des technologies de découpe automatique en continu car cette phase du produit se présente sous forme d'une bande de grande longueur que l'on pourra bobiner.

La seconde phase est le pliage transversal de la bande tel que représenté figure 5. Cette opération s'effectue de préférence en deux temps sur des contre-formes tel que schématisé aux figures 6 et 7 avec des directions de pliage 17 et 18. Les deux pliures, illustrées par les flèches 18, sont effectuées dans une zone de la bande où celle-ci est découpée en lamelles 5 et non dans la région des bordures 8 et 14.

Les bordures 8 et 14 assurent la tenue mécanique et le positionnement de l'ensemble. En outre, elles relient électriquement tous les contacts, ce qui permet d'y répartir le courant électrique lors des opérations d'électrolyse.

Les revêtements électrolytiques sont donc grandement facilités par cette configuration. Ils peuvent être effectués avant ou après pliage dans la configuration de la figure 4 out de la figure 5.

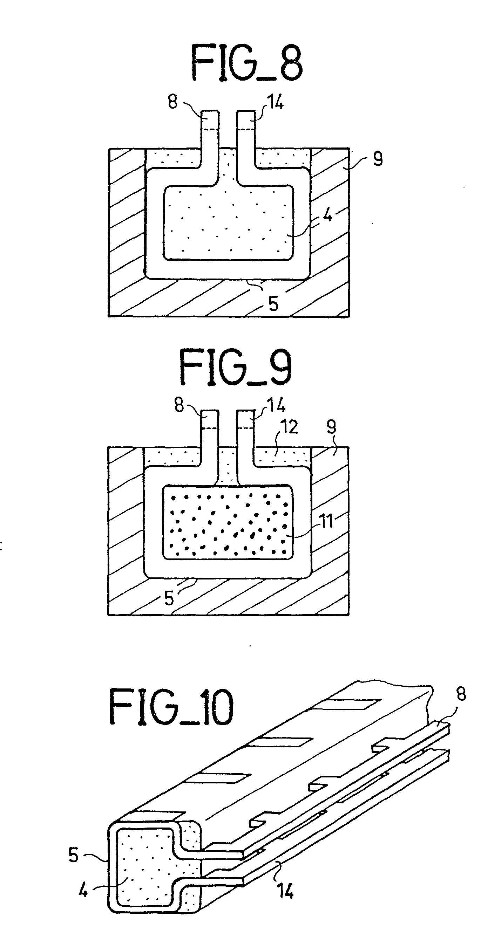

A titre d'exemple, les parties métalliques seront revêtues d'une couche d'environ 2 microns de Nickel sur laquelle on déposera 1 micron d'or. La phase suivante consiste à placer la grille découpée dans un moule dont la configuration interne est conçue de telle sorte que les éléments conducteurs 5 prennent appui sur les parois comme représenté à la figure 8. L'élastomère 4 est polymérisé dans le moule de façon à n'enrober complètement que les parties rapprochées de la grille. Les parties destinées à assurer le contact doivent, elles, rester à nu sur leur face extérieure.

L'appui qu'on leur fait exercer sur les parois du moule au moment de l'insertion de la grille dans ce moule a pour objet d'empêcher la polymérisation sur les faces externes.

Cette action est renforcée par l'utilisation d'un moule recouvert de caoutchouc non adhérent à l'élastomère 4 utilisé.

Une autre technique est décrite dans la figure 9. Un parallélépipède 11 d'élastomère prépolymérisé est placé dans la série d'anneaux parallèles formés par les lamelles. Le tout est introduit dans le moule 9. Le moulage est complété ensuite par la polymérisation du même type d'élastomère en 12. Les parties 12 et 11 constituées par exemple du même matériau possèdent une excellente adhérence, par exemple en silicone.

L'invention se présente alors selon la figure 10 et il ne reste plus qu'à couper les bordures 8 et 14 pour obtenir le produit final décrit en figure 3.

A noter qu'il peut être avantageux de n'effectuer les traitements électrolytiques qu'avant cette dernière étape. La technologie selon l'invention offre alors la possibilité d'effectuer des revêtements uniquement sur les zones utiles, externes, ce qui est une source d'économie dans le cas de l'utilisation de métaux précieux tels que l'or.

Le composite suivant l'invention peut être utilisé dans de nombreuses configurations de connexion. Pour établir la connexion il faut l'appuyer contre les plans rigides comportant les pistes à connecter. Ces plans sont soit des cartes de circuit imprimé, soit des composants pour report à plat tels que les micro-boîtiers.

Le composite sera donc de préférence inséré dans un élément rigide isolant qui le positionnera, l'ensemble constituant le connecteur.

## Revendications

1. Elément de connexion miniature à faible pas, comprenant un corps en élastomère (4) isolant portant des éléments conducteurs disposés pour partie autour dudit corps (4) et noyés pour partie dans ledit corps au voisinage de leurs extrémités, et dont leurs extrémités (13) affleurent à la surface du corps (4) caractérisé en ce que les éléments conducteurs sont des lamelles (5) et que les parties des lamelles (5) noyées dans le corps (4) présentent au moins un pli.

2. Elément de connexion selon la revendication 1, caractérisé en ce que l'élastomère isolant est du silicone.

3. Elément de connexion selon la revendication 1, caractérisé en ce que les lamelles (5) sont réalisée en l'un des matériaux suivants: cuivre, alliage de cuivre.

4. Elément de connexion selon la revendication 1, caractérisé en ce que les lamelles (5) sont recouvertes d'un revêtement métallique de manière à assurer la fiabilité du contact électrique.

5. Elément de connexion selon la revendication 1, caractérisé en ce que le corps isolant a la forme d'un parallélépipède de section rectangulaire.

6. Procédé de fabrication d'un élément de connexion tel que décrit selon l'une quelconque des revendications précédentes, caractérisé en ce qu'il comprend les différentes étapes suivantes:

– une étape de découpe d'une bande en matériau conducteur de manière à obtenir une série de lamelles (5) parallèles entre elles, séparées par des interstices (16) et reliées entre elles en leurs deux extrémité par deux bordures pleines (8, 14);

– une étape de pliage transversal de cette bande, tout en la maintenant par ses deux bordures (8, 14) pleines de manière à former des anneaux presque refermés par les lamelles (5);
– une étape d'introduction de cette bande dans un moule (9) de telle manière qu'une partie des faces extérieures de lamelles prenne appui sur les parois de ce moule (9);
– une étape d'introduction et de polymérisation d'un élastomère (4) dans ce moule (9), de manière à ce que le niveau de l'élastomère n'atteigne pas les bordures (8, 14) de la bande tout en enrobant les pliures des lamelles;
– une étape de découpe des bordures (8, 14) de la bande.

7. Procédé selon la revendication 6, caractérisé en ce qu'il comporte une étape de revêtement électrolytique.

8. Procédé selon la revendication 7, caractérisé en ce que cette étape de revêtement électrolytique est réalisée après l'étape de découpe et avant l'étape de pliage.

9. Procédé selon la revendication 7, caractérisé en ce que cette étape de revêtement électrolytique est réalisée après l'étape de pliage et avant l'étape d'introduction de la bande dans un moule (9).

10. Procédé selon la revendication 7, caractérisé en ce que cette étape de revêtement électrolytique est réalisée après l'étape d'introduction et de polymérisation de l'élastomère et avant l'étape de découpe des bordures (8, 14) de la bande.

11. Procédé selon la revendication 7, caractérisé en ce que cette étape de dépôt électrolytique comporte une phase de dépôt d'une couche de nickel puis une phase de dépôt d'une couche d'or.

12. Procédé selon la revendication 6, caractérisé en ce qu'il comporte, avant l'étape d'introduction de la bande dans le moule, une étape de positionnement d'un parallélépipède du même élastomère (11), prépolymérisé, dans les anneaux formés par les lamelles (5) de la bande, le tout étant alors introduit dans le moule (9).


**Patentansprüche**

1. Ein Miniaturverbindungselement mit kleinen Stufen, welches einen isolierenden Elastomerkörper (4) aufweist, der Leiterelemente trägt, die zum Teil um den Körper (4) herum angeordnet sind, und zum Teil in dem Körper, in der Nähe ihrer Enden eingebettet sind, und deren Enden (13) mit der Oberfläche des Körpers (4) auf gleicher Ebene liegen, dadurch gekennzeichnet, dass die Leiterelemente Lamellen (5) sind, und dass die in dem Körper (4) eingebetteten Teile der Lamellen (5) mindestens einen Knick aufweisen.

2. Verbindungselement nach Anspruch 1, dadurch gekennzeichnet, dass das isolierende Elastomer aus Silicon besteht.

3. Verbindungselement nach Anspruch 1, dadurch gekennzeichnet, dass die Lamellen (5) aus einem der folgenden Materialien ausgeführt sind: Kupfer, Kupferlegierung.

4. Verbindungselement nach Anspruch 1, dadurch gekennzeichnet, dass die Lamellen (5) mit einem Metallmantel umhüllt sind, und zwar in der Weise, dass die Zuverlässigkeit des elektrischen Kontakts sichergestellt ist.

5. Verbindungselement nach Anspruch 1, dadurch gekennzeichnet, dass der Isolierkörper die Form eines Parallelepipedes mit rechteckigem Querschnitt aufweist.

6. Verfahren zur Herstellung eines Verbindungselementes, gemäss einem beliebigen der vorhergehenden Ansprüche, ist dadurch gekennzeichnet, dass es die folgenden, verschiedenen Schritte aufweist:
– einen Schritt des Ausstanzens eines aus leitendem Material bestehenden Bandes, derart, dass eine Serie von parallelen Lamellen (5) entsteht, die durch Zwischenräume (16) getrennt sind und die an ihren zwei Enden durch zwei volle Ränder (8, 14) verbunden sind;
– einen Schritt des Querbiegens des Bandes, wobei das Band an seinen beiden vollen Rändern derart gehalten wird, dass durch die Lamellen (5) ein sich fast wieder schliessender Ring gebildet wird;
– einen Schritt des Einführens dieses Bandes in eine Form (9) derart, dass ein Teil der Aussenseiten der Lamellen an den Innenwänden der Form (9) abgestützt ist;
– einen Schritt des Einführens und der Polymerisation eines Elastomers (4) in die Form (9), derart, dass das Niveau des Elastomers nicht die Höhe der Ränder (8, 14) des Bandes erreicht, wobei die Kanten der Lamellen umhüllt sind;
– einen Schritt des Abschneidens der Ränder (8, 14) des Bandes.

7. Verfahren nach Anspruch 6, dadurch gekennzeichnet, dass ein Schritt des elektrolytischen Überziehens vorgesehen ist.

8. Verfahren nach Anspruch 7, dadurch gekennzeichnet, dass der Schritt des elektrolytischen Überziehens nach dem Schritt des Ausstanzens, und vor dem Schritt des Biegens, durchgeführt wird.

9. Verfahren nach Anspruch 7, dadurch gekennzeichnet, dass der Schritt des elektrolytischen Überziehens nach dem Schritt des Biegens, und vor dem Schritt des Einführens des Bandes in die Form (9), durchgeführt wird.

10. Verfahren nach Anspruch 7, dadurch gekennzeichnet, dass der Schritt des elektrolytischen Überziehens nach dem Schritt des Einführens und der Polymerisation des Polymers, und vor dem Schritt des Abschneidens der Ränder (8, 14) des Bandes, durchgeführt wird.

11. Verfahren nach Anspruch 7, dadurch gekennzeichnet, dass der Schritt des elektrolytischen Überziehens, das Überziehen mit einer Nickelschicht und dann das Überziehen mit einer Goldschicht, vorsieht.

12. Verfahren nach Anspruch 6, dadurch gekennzeichnet, dass vor dem Schritt des Einführens des Bandes in die Form ein Schritt des Positionierens eines Parallelepipedes desselben, vorpolymerisierten, Elastomers (11), in die Ringformen der Lamellen (5) des Bandes, vorsieht, wobei dann das Ganze in die Form (9) eingesetzt wird.

## Claims

1. Miniature small pitch connection element, comprising an insulating elastomer body (4) carrying conducting strips, part of which strips is arranged around said body (4), while the other part is embedded in said body in the region of the strips ends, and which ends (13) are flush with the surface of the body (4), characterized in that the conducting elements are strips (5) and that the parts of said strips (5) which are embedded in the body (4) present at least one fold.

2. Connection element according to claim 1, characterized in that the insulating elastomer is silicone.

3. Connection element according to claim 1, characterized in that the strips (5) are produced from one of the following materials: copper, copper alloy.

4. Connection element according to claim 1, characterized in that the strips (5) are coated with a conducting metal coating for ensuring reliability of electrical contact.

5. Connection element according to claim 1, characterized in that the insulating body is shaped like a parallelepiped of rectangular cross-section.

6. Process for manufacturing a connection element such as described in any one of the preceding claims, characterized in that it comprises the following steps of:
- cutting out a band of conducting material in such a manner as to obtain a series of strips (5) parallel to one another, separated by gaps (16) and connected together at their two ends by two continuous borders (8, 14);
- transversely folding said band, while holding it by its two continuous borders (8, 14) to form rings which are nearly closed by the strips (5);
- introducing said band into a mold (9) such that one part of the outer faces of the strips rests against the walls of said mold (9);
- introducing and polymerizing an elastomer (4) in this mold (9), in such a manner that the level of the elastomer does not reach the borders (8,14) of the band while covering the folds of the strips;
- cutting the borders (8, 14) of the band.

7. Process according to claim 6, characterized in that it comprises an electrolytic coating step.

8. Process according to claim 7, characterized in that said electrolytic coating step is carried out after the cutting off step and before the folding step.

9. Process according to claim 7, characterized in that said electrolytic coating step is carried out after the folding step and before the step of introducing the band into a mold (9).

10. Process according to claim 7, characterized in that said electrolytic coating step is carried out after the step of introducing and polymerizing the elastomer and before the step of cutting the borders (8, 14) of the band.

11. Process according to claim 7, characterized in that said electrolytic coating step comprises a step of depositing a layer of nickel, followed by a phase of depositing a layer of gold.

12. Process according to claim 6, characterized in that it comprises, before the step of introducing the band in the mold, a step of positioning a prepolymerized parallelepiped in the same elastomer (11), in the rings formed by the strips (5) of the band, the whole assembly being then introduced into the mold (9).

FIG_1

2

1

FIG_2

2

1

3

FIG_3

21

4

22

5

13

26

23

16

8

5

FIG_4

14

FIG_5

8

14

5

5

FIG_6

8

14

17

17

5

18

8

14

18

FIG_7

5

# FIG_8

# FIG_9

# FIG_10